(19) Europäisches Patentamt
European Patent Office
Office européen des brevets

(11) **EP 4 645 633 A1**

(12) **EUROPEAN PATENT APPLICATION**

(43) Date of publication:
**05.11.2025 Bulletin 2025/45**

(21) Application number: 24173802.0

(22) Date of filing: **02.05.2024**

(51) International Patent Classification (IPC):
*H02J 7/00* (2006.01)

(52) Cooperative Patent Classification (CPC):
**H02J 7/007182; H02J 7/00714**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventors:
• **AL MOUATAMID, Faouzi**
**417 06 GÖTEBORG (SE)**
• **XU, Yang**
**417 47 GÖTEBORG (SE)**

(74) Representative: **Kransell & Wennborg KB**
**P.O. Box 2096**
**403 12 Göteborg (SE)**

(54) **STATE-OF-POWER PREDICTION USING NESTED CONTROL LOOPS**

(57) A device (100) for State-of-Power (SoP) prediction is provided. The device implements an inner (110) and outer (120) control loop. In the inner loop, an equivalent circuit model (ECM, 130) is used to predict a maximum allowed current ($I'_{max}$) so as not to go beyond a predefined voltage limit ($V_{lim}$) at an end of a predefined time period/interval. A voltage error ($V_{err}$) between the predefined voltage limit and an actual voltage ($V_t$) at the end of the time interval is used to update the ECM. In the outer loop, a current error ($I_{err}$) between the maximum allowed current and an actual current ($I$) at the end of the interval is used to update the same ECM. The ECM is used to predict future voltage $(V_{tp})$, that together with the maximum allowed current is used to determine a maximum power ($P_{max}$) for the interval. A corresponding method is also provided.

EP 4 645 633 A1

**(Cont. next page)**

Fig. 1

**Description**

**TECHNICAL FIELD**

The disclosure relates generally to battery management systems (BMSs), such as found in e.g. electric vehicles. In particular aspects, the disclosure relates to prediction of battery State-of-Power. The disclosure can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

One goal of a battery management system (BMS) may be to extract as much power and/or energy as possible out of each cell of a battery, without violating any of their respective limits. For this purpose, the BMS may rely on predictions of so-called battery State-of-Power (SoP) that provides an indication of how much power that can be extracted from (or put into) a battery during a predetermined time interval without violating any cell limits (such as in terms of current, voltage, temperature, etc.). A common practice is to set conservative power limits for the BMS to operate within, in order to reduce the risk of any such violations. By using sufficient margins, one may thus ensure that e.g. cell current and/or voltage limits will not be violated. This does, however, limit the battery power output and therefore also the capabilities of whatever entity in which the battery is used, such as for example an electric vehicle.

Available solutions to this issue include the use of so-called adaptive SoP-prediction algorithms, wherein predicted cell voltage error is minimized by tuning one or more parameters of the SoP-prediction algorithm. This may result in for example a more accurate maximum current prediction that may be used for the predefined time interval. In many applications, power output/input from/to the battery follows a constant power limit that can be guaranteed for the predefined time interval. This power limit should respect the maximum current prediction, and requires an accurate cell terminal voltage-prediction model for the predefined time interval. Available solutions may however suffer from inaccuracies wherein e.g. overestimation of current and/or voltage may result in current and/or voltage overshoot, which may for example cause additional wear of the battery or similar.

The present disclosure aims at further developing such SoP-prediction algorithms and to mitigate one or more shortcomings thereof.

**SUMMARY**

According to a first aspect of the disclosure, there is provided a device for State-of-Power (SoP) prediction for an energy storage element. The device includes circuitry (such as processing circuitry) configured to implement an inner control loop in which: an equivalent circuit model (ECM) for the energy storage element is used to predict a maximum allowed current for (e.g. through) the energy storage element within a predefined time interval (e.g. up until a predefined time horizon), so as not to go beyond a predefined voltage limit for the energy storage element at an end of the predefined time interval (e.g. at the end of the predefined time horizon); a voltage error is determined as a difference between the predefined voltage limit and an actual voltage of the energy storage element at the end of the predefined time interval; and the determined voltage error is used to update the ECM. The circuitry is further configured to also implement an outer control loop in which: a current error is determined as a difference between the predicted maximum current and an actual current for (e.g. through) the energy storage element at the end of the predefined time interval; and the determined current error is also used to update the ECM. The circuitry is further configured to also use the ECM to predict a voltage of the energy storage element for the predefined time interval (e.g. a predicted voltage of the energy storage element at the end of the predefined time interval), and to use the predicted voltage and the predicted maximum allowed current to determine a maximum power for the energy storage element for the predefined time interval. The first aspect of the disclosure may seek to solve the problem of current and/or voltage overshoot due to e.g. overestimation or underestimation of predicted current and/or voltage. A technical benefit may include that the nested control loops enables to update the ECM, and thus arrive at better predictions with time, based on estimated prediction errors of both current and voltage. This may for example reduce the risk of current and/or voltage overshoot, and thereby result in fewer or no violations of limits for the energy storage element. As used herein, an "energy storage element" may be a battery cell, a battery module including multiple battery cells, a batter pack including one or more battery modules (or multiple battery cells, if using e.g. a cell-to-pack architecture), and similar.

Optionally in some examples, including in at least one preferred example, an update frequency of the inner loop may be faster than an update frequency of the outer loop. For example, the inner loop may update the ECM at least once per predefined time interval, while the outer loop may update the ECM more seldom than that.

Optionally in some examples, including in at least one preferred example, the ECM may be an n:th order resistor-capacitance (RC) model. A technical benefit may include that such a model may be suitable to model e.g. an energy storage element in form of for example a battery cell.

Optionally in some examples, including in at least one preferred example, the ECM may be a first order RC model. A technical benefit may include that such a model may sufficiently capture the necessary dynamics of the energy storage element (e.g. a battery cell) with fewer adjustable parameters than in for example a higher-order RC model.

Optionally in some examples, including in at least one preferred example, the voltage error (for the energy storage element) may be used to update an assumed instantaneous resistance of the energy storage element in the ECM.

Optionally in some examples, including in at least one preferred example, the current error (for the energy storage element) may be used to update an assumed polarization resistance of the energy storage element in the ECM.

Optionally in some examples, including in at least one preferred example, the current error (of the energy storage element) may be used to update an expression for a voltage across a parallel-coupled RC branch of the RC model.

Optionally in some examples, including in at least one preferred example, the maximum allowed current (for/through the energy storage element) may be found as a minimum of a maximum allowed current (for/through the energy storage element) found based on the ECM and a predefined current limit for/through the energy storage element. A technical benefit may include that such a procedure may keep the current through the energy storage element within the limits of the latter.

According to a second aspect of the disclosure, there is provided a battery management system (BMS). The BMS includes the device for SoP-prediction of the first aspect. The second aspect of the disclosure may seek to provide a BMS with enhanced SoP-prediction capabilities. A technical benefit may include or be similar to that already described with reference to the device of the first aspect.

According to a third aspect of the disclosure, there is provided an energy storage system (ESS). The ESS includes at least one energy storage element (e.g. at least one battery pack, battery module and/or battery cell), and the device of the first aspect or(/and) the BMS of the second aspect. The ESS is configured to control a discharging and/or charging of the at least one energy storage element for the predefined time interval based on the determined maximum power (for the energy storage element) obtained from the device and/or BMS. The third aspect of the disclosure may seek to provide an ESS with enhanced SoP-prediction capabilities. A technical benefit may include or be similar to that already described with reference to the device of the first aspect and/or the BMS of the second aspect.

According to a fourth aspect of the disclosure, there is provided an electric vehicle (EV; also referred to as e.g. a battery electric vehicle, BEV, or similar). The EV includes the ESS of the third aspect. The fourth aspect of the disclosure may seek to provide an EV with enhanced SoP-prediction. A technical benefit may include or be similar to that already described with reference to the device of the first aspect, the BMS of the second aspect, and/or the ESS of the third aspect.

Optionally in some examples, including in at least one preferred example, the EV may be a heavy (or heavy-duty) electric vehicle, such as e.g. an electric truck, dumper, bus, or similar. As used herein, the term "vehicle" also includes equipment sometimes referred to as "machines", such as for example wheel loaders, excavators, or similar.

According to a fifth aspect of the disclosure, there is provided a computer-implemented method for SoP-prediction for an energy storage element. The method is performed on/by circuitry (such as processing circuitry), and includes implementing an inner control loop in which: an ECM for an energy storage element is used to predict a maximum allowed current for/through the energy storage element within a predefined time interval (e.g. up until a predefined time horizon), so as not to go beyond a predefined voltage limit for the energy storage element at an end of the predefined time interval; a voltage error is determined as a difference between the voltage limit and an actual voltage of/for the energy storage element at the end of the predefined time interval; and the determined voltage error is used to update the ECM. The method further includes implementing also an outer control loop in which: a current error is determined as a difference between the predicted maximum current and an actual current of/through the energy storage element at the end of the predefined time interval; and the determined current error is also used to update the ECM. The method further includes using the ECM to predict a voltage for the energy storage element for the predefined time interval, and using the predicted voltage and the predicted maximum allowed current to determine a maximum power for the energy storage element for the predefined time interval. Phrased differently, the method includes performing the operations corresponding to those of the device of the first aspect.

According to a sixth aspect of the disclosure, there is provided a computer program product including program code for performing, when executed by circuitry (such as processing circuitry) the method of the fifth aspect.

According to a seventh aspect of the disclosure, there is provided a computer-readable storage medium including instructions, which when executed by circuitry (such as processing circuitry), cause the circuitry to perform the method of the fifth aspect. The storage medium may be non-transitory.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

**FIG. 1** schematically illustrates the functioning of a device for SoP-prediction using a block diagram, according to one or more examples of the present disclosure.

**FIG. 2** schematically illustrates a flowchart of a (computer-implemented) method for SoP-prediction, according to one or more examples of the present disclosure.

**FIG. 3** schematically illustrates an ECM for an energy storage element, according to one or more examples of the present disclosure.

**FIG. 4A** schematically illustrates an ESS, BMS and EV, according to examples of the present disclosure.

**FIG. 4B** schematically illustrates an ESS and BMS, according to examples of the present disclosure.

**FIG. 5** illustrates a schematic diagram of a computer system for implementing examples disclosed herein, according to one or more examples of the present disclosure.

**FIGS. 6A** and **6B** schematically illustrate various curves of actual and predicted current, voltage and power for an energy storage element, with and without a solution as envisaged herein.

## DETAILED DESCRIPTION

The detailed description set forth below provides information and examples of the disclosed technology with sufficient detail to enable those skilled in the art to practice the disclosure.

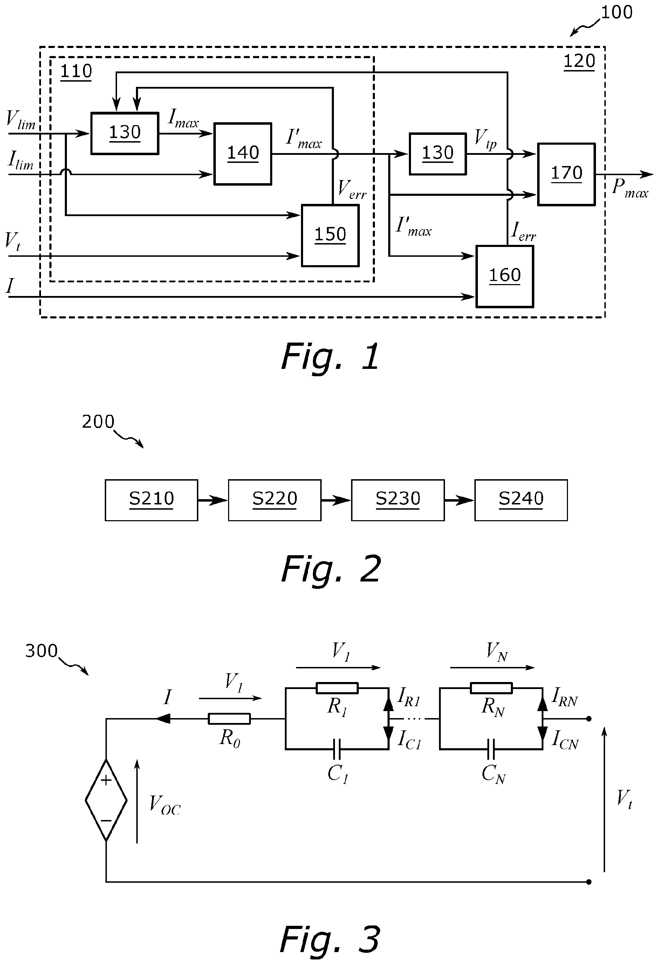

With reference to FIGS. 1 and 2, how the present disclosure envisages to more accurately predict State-of-Power (SoP) for an energy storage element will now be described in more detail. As envisaged herein, an "energy storage element" may for example be a battery cell, a battery module (including multiple battery cells), a battery pack (including e.g. multiple battery modules or at least multiple battery cells), and similar. In what follows, for illustrative purposes only, it will be assumed that the energy storage element is a battery cell, and that an equivalent circuit model (ECM) suitable to sufficiently describe e.g. the static and dynamic behavior of such a battery cell is available. If the energy storage element is instead something else, such as a battery module or battery pack, it is envisaged that the ECM is changed to instead represent such another entity.

**FIG. 1** is a block diagram that schematically illustrates an example device 100 for SoP-prediction for an energy storage element as envisaged herein, wherein as mentioned above the energy storage element is in this example assumed to be a battery cell.

**FIG. 2** schematically illustrates a flowchart of an example method 200 of SoP-prediction, such as performed by the device 100.

The device 100 is configured to implement at least two control loops, namely an inner control loop 110 and an outer control loop 120.

In the inner control loop 110 (as part of an operation S210 of the method 200), an equivalent circuit model (ECM) 130 for the battery cell is used to predict (as part of e.g. an operation S212 of the method 200) a maximum allowed current $I'_{max}$ for the battery cell within a predefined time interval, such that a voltage of (e.g. across) the battery cell does not go beyond a predefined voltage limit $V_{lim}$ during/within a predefined time interval. The maximum allowed current $I'_{max}$ may correspond directly to a maximum current $I_{max}$ obtained from the ECM 130, or e.g. be the result of limiting the current $I_{max}$ to stay within a predefined limit $I_{lim}$, i.e. such that $I'_{max} = \min\left(I_{lim}, I_{max}\right)$, using e.g. a functional block 140 configured to perform such limitation. Phrased differently, in some examples of the device 100, the block 140 may be optional and $I'_{max}$ instead obtained as $I'_{max} = I_{max}$. The predefined limit $I_{lim}$ may for example be provided by a manufacturer of the battery cell, or obtained otherwise (taking into account e.g. temperature restriction requirements or similar). As envisaged herein, it is also desirable if the voltage of the battery cell remains close to the limit $V_{lim}$ at the end of the predefined time interval, i.e. such that the battery cell voltage does not exceed or go much below $V_{lim}$ (in case of charging) or does not go below or go much above $V_{lim}$ (in case of discharging). Ideally, to maximize power usage, the battery cell voltage should equal $V_{lim}$ at the end of the predefined time interval.

The predefined voltage limit $V_{lim}$ may be a maximum voltage that the battery cell is not allowed to go above, which is relevant during e.g. charging of the battery cell. If instead considering a discharging scenario, the voltage limit $V_{lim}$ may

instead be a minimum voltage that the battery cell is not allowed to go below. Such voltage limits may for example be defined by a manufacturer of the battery cell, or obtained using other measures. The ECM 130 may, as will be described in more detail later herein, also be provided with one or more other input parameters (not shown in FIG. 1), such as e.g. an estimated open-circuit voltage of the battery cell or e.g. one or more other values from which such a voltage may be derived/estimated (such as e.g. a State-of-Charge, SoC, of the battery cell, or similar).

Phrased differently, the ECM 130 may be used to estimate a maximum current through the battery cell that, if kept constant during the predefined time interval, will result in the voltage of the battery cell reaching the voltage limit at the end of the predefined time interval. For example, if the predefined time interval is defined as [$kh$, $kh + h$], where $k$ is an integer time index and $h$ is the length of the predefined time interval, $I'_{max}[kh]$ may be calculated/estimated such that if the current through the battery cell between time $kh$ and $kh + h$ is kept fixed and equal to $I'_{max}[kh]$, a voltage $V_t$ of the battery cell at time $kh + h$ will equal $V_{lim}$, i.e. $V_t[kh + h] = V_{lim}$. More generally, it may not necessarily be assumed that all succeeding time intervals are of a same length, but for the purpose of explaining the concept underlying the present disclosure, such an assumption will be made.

The device 100 is further configured to determine (as part of e.g. an operation S214), as part of the inner control loop 110, a voltage error $V_{err}$ defined as a difference between the predefined voltage limit $V_{lim}$ and the actual voltage $V_t$ of the battery cell at the end of the predefined time interval, i.e. $V_{err}[kh + h] = V_{lim} - V_t[kh + h]$ where $V_t[kh + h]$ is the actual voltage across the battery cell sampled/read at time $kh + h$. This may be achieved by the use of a module 150 configured to perform such a determination, wherein the module 150 receives $V_{lim}$ and $V_t$ as inputs and outputs the voltage error $V_{err}$. After the voltage error $V_{err}$ is determined, the inner control loop 110 updates (as part of e.g. an operation S216) the ECM 130 based on the voltage error $V_{err}$.

In the outer control loop 120 (as part of an operation S220 of the method 200), the (predicted) maximum allowed current $I'_{max}$ is compared with an actual current $I$ through the battery cell, in order to determine (as part of e.g. an operation S222 of the method 200) a current error $I_{err}$ defined as a difference between the predicted maximum current $I'_{max}$ and the actual current $I$, i.e. such that $I_{err} = I'_{max} - I$. This may be achieved by the use of a module 160 configured for perform such a determination, wherein the module 160 receives $I'_{max}$ from the inner control loop 110 as well as the actual current $I$ and outputs the current error $I_{err}$. The current error $I_{err}$ is e.g. calculated at the end of the predetermined time interval, to obtain $I_{err}[kh + h] = I'_{max}[kh] - I[kh + h]$, where $I[kh + h]$ is e.g. the actual current sampled/read at time $kh + h$. After the current error $I_{err}$ has been determined, the outer control loop 120 also updates (as part of e.g. an operation S224 of the method 200) the ECM but now based on $I_{err}$.

The outer control loop 120 is further configured to use the ECM 130 of the battery cell to, based on the predicted maximum current $I'_{max}$, predict (as part of an operation S230 of the method 200) a voltage $V_{tp}$ for the battery cell for the predefined time interval, i.e. to predict what the actual voltage $V_t$ of the battery cell will be at the end of the time interval, i.e. such that if the prediction is perfect, $V_{tp}[kh + h]$ would equal $V_t[kh + h]$. Based on the predicted voltage $V_{tp}$ and the predicted maximum allowed current $I'_{max}$, the outer control loop 120 further determines (as part of an operation S240 of the method 200) a maximum power $P_{max}$ for the battery cell for the predetermined time interval, e.g. such that $P_{max}[kh] = V_{tp}[kh + h] * I'_{max}[kh]$ is the determined power that may be drawn from (in case of discharging) or provided to (in case of charging) the battery cell during the time interval from $kh$ to $kh + h$. For example, during a discharge scenario, $P_{max}$ is the predicted maximum (constant) power that may be output from the battery cell during the time interval from $kh$ to $kh + h$, where $h$ is the length (or horizon) of the interval. The method 200 thus results in a SoP-prediction for the battery cell over a predefined time interval.

For example, during a discharging scenario, it may be assumed that outputting the constant power $P_{max}$ during the predefined time interval would make the current through the battery cell increase and converge to $I'_{max}$, while the battery cell voltage would decrease and converge to $V_{lim}$. Any deviations between the actual current $I$ and the predicted maximum current $I'_{max}[kh]$ would be captured in the current error $I_{err}$ and used to update/refine the ECM 130 to provide better predictions. Likewise, any deviations between the actual voltage $V_t$ and the predefined voltage limitation $V_{lim}$ would

also be captured in the voltage error $V_{err}$ and used to update/refine the ECM 130 to provide better predictions.

Both of the inner and outer control loops 110 and 120 are preferably updated no more often than once per time interval, i.e. at most once between *kh* and *kh + h*. The inner control loop 110 preferably operates with a higher update frequency than that of the outer control loop 120, which may allow e.g. disturbances from parameters of the inner control loop 110 to be rejected before they are propagated to the outer loop 120.

Although illustrated as being part of the outer control loop 120, the operation S230 of predicting the voltage $V_{tp}$, and the operation S240 of determining the maximum power $P_{max}$, may in some examples be considered as being outside of the outer control loop 120, e.g. if updating of the ECM 130 based on the current error $I_{err}$ is performed more often than the prediction of $V_{tp}$ and/or determining of $P_{max}$.

Examples of an ECM for a battery cell will now be described in more detail with reference also to FIG. 3.

**FIG. 3** schematically illustrates a circuit diagram of an ECM 300 for a battery cell, in the form of a so-called n:th order RC model (also referred to as Thevenin model). As envisaged herein, there may of course be other ECM's suitable to describe e.g. static and dynamic behavior of the battery cell. However, in what follows, the RC model illustrated in FIG. 3 will be used to describe one example.

The ECM 300 includes a voltage source $V_{oc}$ considered to represent an open-circuit (i.e. no-load) voltage of the battery cell. In series with the voltage source $V_{oc}$ is provided a resistance $R_0$, which may be considered as an instantaneous resistance of the battery cell in the ECM 300.

In series with the voltage source $V_{oc}$ and the resistance $R_0$ is also provided one or more pairs of parallelly connected resistances and capacitances, i.e. pairs of a resistor $R_i$ and a capacitor $C_i$, where *i* indicates the *i*:th such pair out of a total of *N* pairs. The number of pairs decides the order of the RC model, such that e.g. if only a single pair $R_1$ and $C_1$ is provided, the RC model is said to be of first order; if two pairs $R_1$ and $C_1$, and $R_2$ and $C_2$, are provided, the RC model is said to be of second order, and so on.

Following from Kirchhoff's voltage law, an output/terminal voltage $V_t$ of the battery cell may be defined as

$$V_t(t) = V_{oc}(t) + V_0(t) + \sum_{i=1}^{N} V_i(t),$$

where $V_i(t)$ is the voltage across the *i*:th R/C-pair at time *t* as indicated in FIG. 3. In what follows, for explanatory purposes only, it will be assumed that only a single pair $R_1$ and $C_1$ is provided and that the ECM 300 is thus a first order RC model, i.e. such that

$$V_t(t) = V_{oc}(t) + V_0(t) + V_1(t). \tag{1}$$

In the above expressions, $V_{oc}$ may be assumed to depend on e.g. a State-of-Charge (SoC) of the battery cell, such that $V_{oc}(t) = V_{oc}(SoC(t))$.

The voltage $V_0$ across the resistance $R_0$ is

$$V_0(t) = R_0 I(t), \tag{2}$$

and, equivalently, the voltage $V_1$ across the resistor $R_1$ is

$$V_1(t) = R_1 I_{R1}(t), \tag{3}$$

where $I(t)$ is the battery cell current, and $I_{R1}(t)$ is the current through the branch of the RC-pair including the resistance $R_1$, as indicated in FIG. 3, and where the direction/sign of the current *I* depends on whether the battery cell is currently discharging or charging.

With the use of equation (2), equation (1) may be rewritten as

$$V_t(t) = V_{oc}(t) + R_0 I(t) + V_1(t). \tag{4}$$

From Kirchhoff's current law, it follows that the combined currents through the two branches of the RC-pair should equal the current *I*, i.e. that

$$I(t) = I_{R1}(t) + I_{C1}(t), \qquad (5)$$

or, equivalently by using also equation (3), that

$$I_{C1}(t) = I(t) - \frac{V_1(t)}{R_1}, \qquad (6)$$

where $I_{C1}$ is the current in the branch including the capacitance $C_1$. The current $I_{C1}$ depends on the time-derivative of the voltage $V_1$ as

$$I_{C1}(t) = C_1 \frac{dV_1(t)}{dt}, \qquad (7)$$

from which follows, by combing equations (6) and (7), that

$$\frac{dV_1(t)}{dt} = -\frac{V_1(t)}{R_1 C_1} + \frac{I(t)}{C_1}. \qquad (8)$$

The dynamics of the ECM 300 is thus as described by equations (4) and (8).

Using conventional solution methods for differential equations on the form $\dot{x}(t) = ax(t) + bu(t)$, equation (8) may be solved as

$$V_1(t) = e^{at} V_1(0) + \int_0^t e^{a(t-\tau)} bI(\tau) d\tau, \qquad (9)$$

where $\alpha = -1/(R_1 C_1)$ and $b = 1/C_1$. If evaluating the result of equation (9) at discrete time steps t=$k$h, the voltage $V_1$ may be rewritten as

$$V_1[kh + h] = V_1\big((k+1)h\big) = e^{a(k+1)h} V_1(0) + \int_0^{(k+1)h} e^{a((k+1)h-\tau)} bI(\tau) d\tau$$

$$= e^{ah} e^{akh} V_1(0) + \int_0^{kh} e^{a((k+1)h-\tau)} bI(\tau) d\tau + \int_{kh}^{(k+1)h} e^{a((k+1)h-\tau)} bI(\tau) d\tau$$

$$= \cdots = e^{ah} V_1[kh] + \int_{kh}^{(k+1)h} e^{a((k+1)h-\tau)} bI(\tau) d\tau.$$

If assuming that the current $I$ is constant at least over the interval $k$h to $(k+1)$h, the above expression for $V_1[kh + h]$ can be further simplified to

$$V_1[kh + h] = e^{ah} V_1[kh] + \frac{1}{a}\big(e^{ah} - 1\big) bI[kh].$$

From equation (4), the terminal voltage $V_t$ of the battery cell may thus be expressed as

$$V_t[kh] = V_{oc}[kh] + R_0 I[kh] + V_1[kh]$$

$$= V_{oc}[kh] + R_0 I[kh] + e^{ah} V_1[kh - h] + \frac{1}{a}(e^{ah} - 1)bI[kh - h]$$

$$= V_{oc}[kh] + R_0 I[kh] + \alpha(R_1, C_1)V_1[kh - h] + (1 - \alpha(R_1, C_1))R_1 I[kh - h], \qquad (10)$$

where $\alpha(R_1, C_1) = e^{-h/(R_1 C_1)}$.

The inner control loop 110 of the device 100 may be configured to determine the maximum allowed current $I_{max}$ using the ECM 300 and in accordance with e.g. the above equation (10), in which case it may be assumed that $I[kh] = I_{max}$ (i.e. the current is kept constant) over the time interval from $kh$ to $kh + h$. Under such an assumption, equation (10) may be rewritten as

$$V_t[kh] = V_{oc}[kh] + R_0 I_{max} + \alpha(R_1, C_1)V_1[kh - h] + (1 - \alpha(R_1, C_1))R_1 I_{max}, \qquad (11)$$

from which it may be extracted that, if assuming that $V_t[kh] = V_{lim}$,

$$I_{\max}[kh] = \frac{V_{lim} - V_{oc}[kh] - \alpha(R_1, C_1)V_1[kh - h]}{R_0 + (1 - \alpha(R_1, C_1))R_1}, \qquad (12)$$

where $\alpha(R_1, C_1) = e^{-h/(R_1 C_1)}$.

Similar equations may also be derived for different ECM's, such as e.g. for a higher-order RC-model or similar, and used by the device 100.

If for example utilizing the solution as envisaged herein in an electric vehicle, the vehicle may be controlled to follow the maximum allowed current $I'_{max}$ (found based on $I_{max}$) over the predefined time interval from $kh$ to $kh + h$. According to the ECM 300, at the end of the time interval, the battery cell voltage $V_t$ should equal $V_{lim}$. Any deviation between $V_t$ (as measured) and $V_{lim}$ at the end of the predefined time interval is considered an error, as defined by $V_{err}$, and is then used in the inner control loop 110 to update the ECM 300 in order to adjust the parameters thereof to improve the accuracy of the model. For example, it is envisaged that $V_{err}$ may be used to update the value of the parameter $R_0$ (i.e. the assumed instantaneous resistance of the first-order RC-model, or similar) of the ECM 300. Other examples are of course also possible.

After determining (or predicting) the maximum allowed current $I'_{max}$ (based on $I_{max}$), the device may predict also the maximum allowed constant power $P_{max}$ of the battery cell over the predefined time interval. For example, in a discharging scenario, applying a constant power $P_{max}$ over the predefined time interval would cause the current $I$ to increase and converge towards $I'_{max}$, and the battery cell voltage $V_t$ to decrease and converge towards $V_{lim}$. If the current $I$ at time $kh + h$ differs from $I'_{max}$ as predicted, this may be considered an error, as defined by the current error $I_{err}$. The outer control loop 120 may then use this current error $I_{err}$ to further update the ECM 300. For example, $I_{err}$ may be used to update for example the parameter $R_1$ of the ECM 300 (where $R_1$ may be considered as a polarization resistance of the battery cell), and/or to update $\alpha(R_1, C_1)$, or similar. Other examples are of course also possible. The predicted maximum power $P_{max}$ may be defined as $P_{max} = I'_{max} V_{lim}$.

If used e.g. in an electric vehicle, it is envisaged that the output from the device 100 may be provided to for example a system of the vehicle responsible for controlling an electric traction of the vehicle, and that this system may use e.g. the predicted maximum power $P_{max}$ as part of such control. As part of such control, the vehicle may be operated such that the battery (cell) current follows $I'_{max}$, such that the voltage error $V_{err}$ may be observed. Likewise, as part of such control, the vehicle may be operated such that it follows $P_{max}$, and the current error $I_{err}$ may be observed.

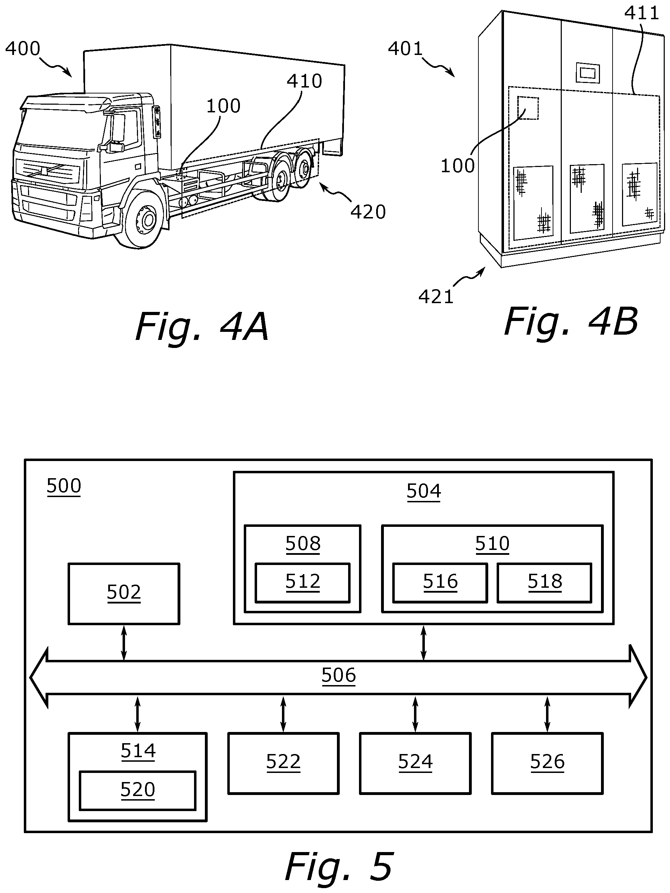

**FIG. 4A** schematically illustrates an example heavy(-duty) electric vehicle as envisaged herein, in form of an electric truck 400. FIG. 4A also serves to illustrate an example energy storage system (ESS) 420 that includes at least one energy storage element (such as at least one battery cell, battery module, battery pack, or similar). The ESS 420 may include the device 100. In other envisaged examples, the device 100 may form part of a battery management system (BMS), and the ESS 420 may e.g. indirectly include the device 100 by including such a BMS. In any case, the truck 400 includes at least one energy storage element and the device 100, and may thus use the device 100 to make predictions about SoP for the energy storage element, which may then be used as part of controlling e.g. an electric traction of the vehicle (such as one or more electrical machines configured to propel the truck 400), or similar, as described herein. Although illustrated herein using a truck 400, a "vehicle" as envisaged herein may be any type of electric vehicle, not necessarily limited to road vehicles. The same solution, including the use of the improved device 100, may e.g. be used in electric marine vessels, electric airplanes, or in any vehicle and/or vessel in which one or more energy storage elements (i.e. batteries and/or battery elements) are used to power an electric propulsion of the vehicle.

**FIG. 4B** schematically illustrates another example of an entity including an ESS as envisaged herein, here in form of a battery bank 401 configured to deliver (or receive) energy to (or from) a power grid, as part of e.g. a backup- and/or ancillary service. The battery bank 401 includes an ESS 421 that includes one or more energy storage elements 411, i.e. on or more battery cells, modules or packs, or similar. The battery bank 401 may for example be installed as part of the power grid itself, and/or be provided e.g. as part of a building or similar.

The ESS 401 and/or the battery bank 401 includes the device 100, in order to provide improved SoP predictions of how much power that may be extracted from (or provided to) the battery bank 401 over a next predefined time interval as described herein. The battery bank 401 may for example include one or more energy storage elements that have been harvested from e.g. an electric vehicle, representing so-called "second use" wherein e.g. battery packs that are no longer considered useful in electric vehicles may still be used in other, less demanding applications, such as home energy storage solutions, off-grid solutions, grid solutions, and similar. In particular, FIG. 4B and the battery bank 401 serve to illustrate that the device 100 (and method 200 performed therein) as envisaged herein is not necessarily applicable only to electric (heavy) vehicles, but may find use in any situation in which there is a need for more accurate SoP-predictions.

**FIG. 5** schematically illustrates a diagram of an example computer system 500 for implementing examples disclosed herein, such as e.g. for implementing all or part of the device 100. The computer system 500 is adapted to execute instructions from a computer-readable medium to perform these and/or any of the functions or processing described herein. The computer system 500 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 500 may include any collection of devices that individually or jointly execute a set (or multiple sets) of instructions to perform any one or more of the methodologies discussed herein, such as all or part of the method 200. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include processing circuitry 502 (e.g., processing circuitry including one or more processor devices or control units), a memory 504, and a system bus 506. The computer system 500 may include at least one computing device having the processing circuitry 502. The system bus 506 provides an interface for system components including, but not limited to, the memory 504 and the processing circuitry 502. The processing circuitry 502 may include any number of hardware components for conducting data or signal processing or for executing computer code stored in memory 504. The processing circuitry 502 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 502 may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processing circuitry 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with processing circuitry 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program 520 stored on a transitory or non-transitory computer-usable or computer-readable storage medium (e.g., single medium or multiple media), such as the storage device 514, which includes complex programming instructions (e.g., complex computer-readable program code) to cause the processing circuitry 502 to carry out actions described herein. Thus, the computer-readable program code of the computer program 520 can comprise software instructions for implementing the functionality of the examples described herein when executed by the processing circuitry 502. In some examples, the storage device 514 may be a computer program product (e.g., readable storage medium) storing the computer program 520 thereon, where at least a portion of a computer program 520 may be loadable (e.g., into a processor) for implementing the functionality of the examples described herein when executed by the processing circuitry 502. The processing circuitry 502 may serve as a controller or control system for the computer system 500 that is to implement the functionality described herein.

The computer system 500 may include an input device interface 522 configured to receive input and selections to be communicated to the computer system 500 when executing instructions, such as from a keyboard, mouse, touch-sensitive surface, etc. Such input devices may be connected to the processing circuitry 502 through the input device interface 522 coupled to the system bus 506 but can be connected through other interfaces, such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may include a communications interface 526 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

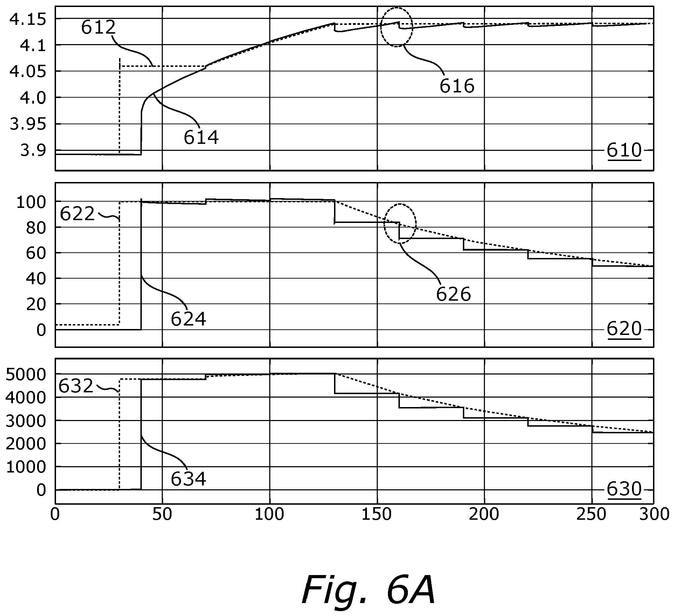

FIG. 6A illustrates various plots of voltage (610), current (620) and power (630) curves as a function of time (in arbitrary units), in a situation in which discharging of an energy storage element follows predicted SoP (over multiple 30 second-intervals) not utilizing the solution as envisaged herein. A first curve 612 illustrates predicted battery cell voltage and a second curve 614 illustrates actual (measured) battery cell voltage. A third curve (622) illustrates predicted battery cell current and a fourth curve 624 illustrates actual (measured) battery cell current. A fifth curve (632) illustrates predicted power and a sixth curve (634) illustrate actual (measured) power. With no corrections, it is seen that there are regions 616 and 626 of overshoot of both voltage and current, respectively.

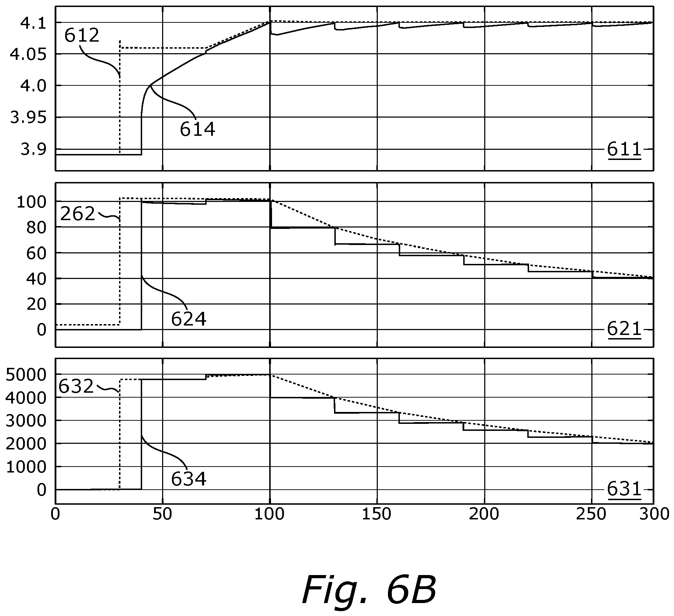

FIG. 6B illustrates similar plots of voltage (611), current (621) and power (631) curves as a function of time (in arbitrary units), but wherein both of the envisaged first and second control loop corrections are used. Here, it is seen that the power limits do not violate the predicted current and that there is no overshoot of current or voltage.

In summary of all of the above, the present disclosure improves upon currently available technology in that provides a device/method capable of more accurate SoP predictions, in particularly obtained by the use of nested control loops in which both voltage and current errors are used to update a same ECM used to predict e.g. maximum allowed current and to predict future voltage of the energy storage element. This may reduce complications following from less-than-accurate predictions, such as overshooting of one or more parameters resulting in e.g. unnecessary heating and/or wear of the energy storage element and/or other system components.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

The following is an exemplifying list of examples envisaged herein:

Example 1: A device (100, 500) for State-of-Power, SoP, prediction for an energy storage element, including circuitry configured to: a) implement an inner control loop (110) in which: - an equivalent circuit model, ECM, (130) for the energy storage element is used to predict a maximum allowed current for the energy storage element within a predefined time interval ([kh,kh+h]) so as not to go beyond a predefined voltage limit for the energy storage element at an end of the predefined time interval; - a voltage error is determined as a difference between the predefined voltage limit and an actual voltage of the energy storage element at the end of the predefined time interval, and - the determined voltage error is used to update the ECM; b) implement an outer control loop (120) in which: - a current error is determined as a difference between the predicted maximum current and an actual current (I) for the energy storage element at the end of the predefined time interval, and - the determined current error is also used to update the ECM; c) use the ECM to predict a voltage of the energy storage element for the predefined time interval, and d) use the predicted voltage and the predicted maximum allowed current to determine a maximum power for the energy storage element for the predefined time interval.

Example 2: The device of example 1, wherein an update frequency of the inner loop is faster than an update frequency of the outer loop.

Example 3: The device of example 1 or 2, wherein the ECM is an n:th order RC model (300).

Example 4: The device of example 3, wherein the ECM is a first order RC model.

Example 5: The device of example 3 or 4, wherein the voltage error is used to update an assumed instantaneous resistance of the energy storage element in the ECM.

Example 6: The device of any one of examples 3 to 5, wherein the current error is used to update an assumed polarization resistance of the energy storage element in the ECM.

Example 7: The device of any one of examples 3 to 6, wherein the current error is used to update an expression for a voltage across a parallel-coupled RC branch of the RC model.

Example 8: The device of any one of the preceding examples, wherein the maximum allowed current is found as a minimum of a maximum allowed current for the energy storage element found based on the ECM and a predefined current limit for the energy storage element.

Example 9: The device of any one of the preceding examples, wherein the device is or form parts of a computer system, and wherein the circuitry is or forms part of processing circuitry of the computer system.

Example 10: A battery management system, BMS, (410, 411) including the device (100) of any one of examples 1 to 9.

Example 11: An energy storage system, ESS, (420, 421), including: - at least one energy storage element, and - the device (100) of any one of examples 1 to 9 or the battery management system (410, 411) of example 10, wherein the energy storage system is configured to control a discharging and/or charging of the at least one energy storage element for the time horizon based on the determined maximum battery cell power.

Example 12: An electric vehicle (400), including the energy storage system (420) of example 11.

Example 13: The electric vehicle of example 12, wherein the electric vehicle is a heavy electric vehicle.

Example 14: A computer-implemented method (200) for State-of-Power, SoP, prediction for an energy storage element, the method being performed on processing circuitry (502), the method including: a) implementing (S210) an inner control loop (110) in which: - an equivalent circuit model, ECM, (130) for the energy storage element is used to predict (S212) a maximum allowed current for the energy storage element within a predefined time interval ([kh, kh+h]), so as not to go beyond a predefined voltage limit for the energy storage element at an end of the predefined time interval; - a voltage error is determined (S214) as a difference between the predefined voltage limit and an actual voltage of the energy storage element at the end of the predefined time interval, and - the determined voltage error is used to update (S216) the ECM; b) implementing (S220) an outer control loop (120) in which: - a current error is determined (S222) as a difference between the predicted maximum current and an actual current for the energy storage element at the end of the predefined time interval, and - the determined battery current error is also used to update (S224) the ECM; c) using (S230) the ECM to predict a voltage of the energy storage element for the predefined time interval, and d) using (S240) the predicted voltage and the predicted maximum allowed current to determine a maximum power for the energy storage element for the predefined time interval.

Example 15: A computer program product including program code for performing, when executed by processing circuitry, the method of example 14.

Example 16: A non-transitory computer-readable storage medium including instructions, which when executed by processing circuitry, cause the processing circuitry to perform the method of example 14.

**Claims**

1. A device (100, 500) for State-of-Power, SoP, prediction for an energy storage element, comprising circuitry configured to:

   a) implement an inner control loop (110) in which:

   - an equivalent circuit model, ECM, (130) for the energy storage element is used to predict a maximum allowed current ($I_{max}$, $I'_{max}$) for the energy storage element within a predefined time interval ([kh, kh + h]) so as not to go beyond a predefined voltage limit ($V_{lim}$) for the energy storage element at an end of the predefined time interval;
   - a voltage error ($V_{err}$) is determined as a difference between the predefined voltage limit and an actual voltage ($V_t$) of the energy storage element at the end of the predefined time interval, and
   - the determined voltage error is used to update the ECM;

   b) implement an outer control loop (120) in which:

   - a current error ($I_{err}$) is determined as a difference between the predicted maximum current and an actual current ($I$) for the energy storage element at the end of the predefined time interval, and
   - the determined current error is also used to update the ECM;

   c) use the ECM to predict a voltage ($V_{tp}$) of the energy storage element for the predefined time interval, and
   d) use the predicted voltage and the predicted maximum allowed current to determine a maximum power ($P_{max}$) for the energy storage element for the predefined time interval.

2. The device of claim 1, wherein an update frequency of the inner loop is faster than an update frequency of the outer loop.

3. The device of claim 1 or 2, wherein the ECM is an n:th order RC model (300).

4. The device of claim 3, wherein the ECM is a first order RC model.

5. The device of claim 3 or 4, wherein the voltage error is used to update an assumed instantaneous resistance ($R_0$) of the energy storage element in the ECM.

6. The device of any one of claims 3 to 5, wherein the current error is used to update an assumed polarization resistance

($R_1$) of the energy storage element in the ECM.

7. The device of any one of claims 3 to 6, wherein the current error is used to update an expression for a voltage ($V_1$) across a parallel-coupled RC branch of the RC model.

8. The device of any one of the preceding claims, wherein the maximum allowed current is found as a minimum of a maximum allowed current for the energy storage element found based on the ECM and a predefined current limit ($I_{lim}$) for the energy storage element.

9. A battery management system, BMS, (410, 411) comprising the device (100) of any one of claims 1 to 8.

10. An energy storage system, ESS, (420, 421), comprising:

    - at least one energy storage element, and
    - the device (100) of any one of claims 1 to 8 or the battery management system (410, 411) of claim 9,

    wherein the energy storage system is configured to control a discharging and/or charging of the at least one energy storage element for the time horizon based on the determined maximum battery cell power.

11. An electric vehicle (400), comprising the energy storage system (420) of claim 10.

12. The electric vehicle of claim 11, wherein the electric vehicle is a heavy electric vehicle.

13. A computer-implemented method (200) for State-of-Power, SoP, prediction for an energy storage element, the method being performed on processing circuitry (502), the method comprising:

    a) implementing (S210) an inner control loop (110) in which:

    - an equivalent circuit model, ECM, (130) for the energy storage element is used to predict (S212) a maximum allowed current ($I_{max}$) for the energy storage element within a predefined time interval ($[kh, kh + h]$), so as not to go beyond a predefined voltage limit ($V_{lim}$) for the energy storage element at an end of the predefined time interval;
    - a voltage error ($V_{err}$) is determined (S214) as a difference between the predefined voltage limit and an actual voltage ($V_t$) of the energy storage element at the end of the predefined time interval, and
    - the determined voltage error is used to update (S216) the ECM;

    b) implementing (S220) an outer control loop (120) in which:

    - a current error ($I_{err}$) is determined (S222) as a difference between the predicted maximum current and an actual current for the energy storage element at the end of the predefined time interval, and
    - the determined battery current error is also used to update (S224) the ECM;

    c) using (S230) the ECM to predict a voltage ($V_{tp}$) of the energy storage element for the predefined time interval, and
    d) using (S240) the predicted voltage and the predicted maximum allowed current to determine a maximum power ($P_{max}$) for the energy storage element for the predefined time interval.

14. A computer program product comprising program code for performing, when executed by processing circuitry, the method of claim 13.

15. A non-transitory computer-readable storage medium comprising instructions, which when executed by processing circuitry, cause the processing circuitry to perform the method of any claim 13.

*Fig. 1*

*Fig. 2*

*Fig. 3*

*Fig. 4A*

*Fig. 4B*

*Fig. 5*

*Fig. 6A*

*Fig. 6B*

EUROPEAN SEARCH REPORT

Application Number

EP 24 17 3802

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 341 508 B (UNIV GUILIN ELECTRONIC TECH) 6 December 2022 (2022-12-06) | 1,2,8-15 | INV. H02J7/00 |
| Y | * figures 1-4 * <br> * paragraph [0037] - paragraph [0047] * <br> * paragraph [0001] * <br> ----- | 3-7 | |
| Y | CN 115 133 520 B (HARBIN INST TECHNOLOGY) 30 May 2023 (2023-05-30) <br> * figure 7 * <br> * paragraph [0082] - paragraph [0098] * <br> ----- | 3-7 | |
| A | CN 116 914 901 A (UNIV CHINA GEOSCIENCES WUHAN) 20 October 2023 (2023-10-20) <br> * figures 1,2 * <br> ----- | 1,13-15 | |

**TECHNICAL FIELDS SEARCHED (IPC)**

H02J

The present search report has been drawn up for all claims

| Place of search | Date of completion of the search | Examiner |
|---|---|---|
| Munich | 10 October 2024 | Despis, Enguerran |

EPO FORM 1503 03.82 (P04C01)

## ANNEX TO THE EUROPEAN SEARCH REPORT
## ON EUROPEAN PATENT APPLICATION NO.

EP 24 17 3802

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2024

| Patent document cited in search report | | Publication date | Patent family member(s) | Publication date |
|---|---|---|---|---|
| CN 110341508 | B | 06-12-2022 | NONE | |
| CN 115133520 | B | 30-05-2023 | NONE | |
| CN 116914901 | A | 20-10-2023 | NONE | |

EPO FORM P0459

For more details about this annex : see Official Journal of the European Patent Office, No. 12/82